# EUROPÄISCHE PATENTSCHRIFT

(11) **EP 2 547 635 B1**
(45) Veröffentlichungstag und Bekanntmachung des Hinweises auf die Patenterteilung: **08.05.2019**
(21) Anmeldenummer: 11708197.6
(22) Anmeldetag: 10.03.2011
(51) Int. Cl.: C04B 35/105, C04B 35/117, C04B 35/12, C23C 14/06, C04B 35/581

(54) **HEXAGONALER MISCHKRISTALL AUS EINEM AL-CR-O-N STOFFSYSTEM**
HEXAGONAL MIXED CRYSTAL MADE OF AN AL-CR-O-N SUBSTANCE SYSTEM
CRISTAL MIXTE HEXAGONAL À BASE D'UN SYSTÈME DE SUBSTANCE AL-CR-O-N

(30) Priorität: 17.03.2010 DE 102010011694
(43) Veröffentlichungstag der Anmeldung: 23.01.2013
(73) Patentinhaber: Karlsruher Institut für Technologie, 76131 Karlsruhe (DE)
(72) Erfinder: JAUCH, Raphael, 78737 Fluorn-Winzeln (DE); LEISTE, Harald, 76356 Weingarten (DE); STÜBER, Michael, 76829 Landau (DE); ULRICH, Sven, 76297 Stutensee (DE); DIECHLE, Dominic, 73033 Göppingen (DE); JAUCH, Raphael, 78737 Fluorn-Winzeln (DE)
(74) Vertreter: Herzog, Fiesser & Partner Patentanwälte PartG mbB
(86) Internationale Anmeldenummer: PCT/EP2011/001171
(87) Internationale Veröffentlichungsnummer: WO 2011/113548

(56) Entgegenhaltungen:
- WO-A1-2007/121954
- WO-A1-2010/040494
- WO-A2-2004/059030
- JP-A- 2004 344 990

## Beschreibung

Die vorliegende Erfindung betrifft einen hexagonalen Mischkristall aus einem Al-Cr-O-N Stoffsystem, und seine Verwendung.

Eine Reihe von Arbeiten befasst sich mit der Entwicklung von keramischen Hochleistungsschichten auf Basis von Aluminiumoxid (Al₂O₃). Diese Hartstoffschichten finden ganz allgemein für Schneidwerkzeuge, Gleitelemente, Formwerkzeuge usw. Einsatz. Für die Anwendung als Hartstoffschicht auf Hartmetallwerkzeugen muss eine Schicht eine hohe Verschleißfestigkeit und Wärmebeständigkeit sowie Oxidationsbeständigkeit bei hohen Temperaturen aufweisen.

Aluminiumoxid besitzt mehrere Phasen. Neben der thermodynamisch stabilen α - Aluminiumoxid Hochtemperaturphase gibt es mehrere metastabile Phasen. Von den metastabilen Phasen besitzt reines γ - Aluminiumoxid oder eine Mischung aus einer γ - und einer α - Phase die größte technische Relevanz. Wenn jedoch, wie im Fall eines Schneidwerkzeugs, die Kantentemperaturen während des Schneidens typischerweise zwischen 800°C und 1000°C liegen, ändert sich die Struktur der metastabilen Aluminiumoxid Phasen, was Probleme wie Risse oder eine Ablösung der Schicht verursacht.

In industriellen Prozessen wird α - Aluminiumoxid vornehmlich mittels chemischer Gasphasenabscheidung (engl. Chemical Vapor Deposition, CVD) abgeschieden. CVD-Prozesse haben den Nachteil das eine hohe Substrattemperatur (typischer Weise 600 °C - 1000 °C) notwendig ist. Diese unerwünschte Wärmebehandlung verursacht Probleme mit der Maßhaltigkeit des Substrats und reduziert die mechanischen Eigenschaften der Substrate. Zum Beispiel eignet sich der CVD-Prozess nicht zur Beschichtung von Schnellarbeitsstahl. Daneben gibt es die physikalische Gasphasenabscheidung (engl. Physical Vapor Deposition, PVD) die die Synthese der α - Aluminiumoxid Phase bei deutlich reduzierten Temperaturen gestattet (typischer Weise 500 °C), wobei die physikalischen Randbedingungen des Plasmas und/oder der Substratoberfläche gezielt eingestellt werden.

Beispielhaft wird durch die Zugabe von Cr zum Al-O Materialsystem die Synthese der α - Phase erleichtert weil Cr₂O₃ isostrukturell zu α-Al₂O₃ ist, die α - Phase stabilisiert, die Aktivierungsschwelle reduziert und die Nukleation unterstützt.

Bekannt sind eine Reihe von Arbeiten das Al-Cr-O-N Stoffsystem betreffend. Ziel der Arbeiten war die Herstellung von Phasenmasken für lithographische Anwendungen (Y. Choi, et al., Japanese Journal of Applied Science, Vol. 41, (2002), S. 5805 - 5808) und für den Einsatz in Festoxid-Brennstoffzellen (A. Kayani, et al., Surface and Coatings Technology, Vol. 201, (2006), S. 1685 - 1694).

Eine weitere Anwendung für Al-Cr-O-N Schichten beschreibt die Beschichtung von Plastifizierschnecken, die bei Kunstoffspritzgußmaschinen eingesetzt werden. Ziel ist die Anhaftung der Kunstoffschmelze auf der Schnecke zu verringern (B. Kirsten, et al.: PVD-Beschichtungen auf Plastifizierschnecken, Kunststoffe, Hanser Verlag, Vol. 8, München (2006), S. 66 - 68).

WO2007/121954 offenbart einen Körper, mit einem Substrat und einer auf dem Substrat aufgebrachten Hartstoffschicht, die den Körper mindestens teilweise bedeckt wobei die Hartstoffschicht Al, Cr und Si sowie ein oder mehrere Elemente aus B, C, N und O enthält. Die Zusammensetzung kann (Al, Cr, Si)203 mit hexagonaler Kristallstruktur sein.

JP2004/344990 offenbart eine Hartstoffschicht mit der Formel (Al1-aCra)O1-dNd wobei a=0.05-0.35 At% und d=0.02-0.10 At%.

WO2004/059030 offenbart eine Haftschicht aus einem Mischkristall enthaltend die Zusammensetzung (AlyCr1-y)X, mit X=NO und mit 0,2=< y < 0,7.

Der Nachteil dieser bekannten Ansätze ist, dass die Al-Cr-O-N Schicht nicht in der α - Phase, also in der wünschenswerten hexagonalen Gitterstruktur, abgeschieden wird und die vorteilhaften Eigenschaften der α - Phase somit nicht nutzbar sind.

Ausgehend davon liegt die **Aufgabe der Erfindung** darin, einen hexagonalen Mischkristall, und seine Verwendung als Hartstoffschicht vorzuschlagen, die die aufgeführten Nachteile und Einschränkungen vermeiden. Insbesondere soll ein sich in der α - Phase, d.h. in hexagonaler Struktur, befindlicher Al-Cr-O-N Mischkristall hergestellt und das Aufbringen dieses Mischkristalls auf ein Substrat ermöglicht werden.

Gelöst wird diese Aufgabe im Hinblick auf den Mischkristall durch einen hexagonalen Mischkristall mit den Merkmalen nach Anspruch 1, und im Hinblick auf die Verwendung gemäß des Anspruchs 6.

Die Unteransprüche geben vorteilhafte Ausgestaltungen der Erfindung Zur Lösung der Aufgabe wird in den Mischkristall das Element Stickstoff in ein Stoffsystem auf der Basis eines Aluminiumoxids in die α - Phase eingebracht. Es wurde gefunden, dass das Einbringen von Stickstoff in der α - Phase zu einer Gitterverspannung führt, die eine Steigerung der Festigkeit und zu einer Verbesserung der mechanischen Eigenschaften der Schicht zur Folge hat.

Die Zusammensetzung der erfindungsgemäßen Hartstoffschicht, die eine hexagonale Gitterstruktur aufweist, wird durch nachstehende Formel dargestellt

α-(Alₓ, Cr₁₋ₓ)_{2+δ} (O_{1-y}, N_{y})₃ (1)

Um die gewünschte Gitterstruktur zu erzielen, muss die chemische Zusammensetzung der Gleichung 1 genügen, wobei α die hexagonale Gitterstruktur bezeichnet und die Werte der Variablen x, y und δ innerhalb der nachfolgend angegebenen Bereiche liegen. Die Variable x einen Wert von 0,1 bis 0,9 und vorzugsweise von 0,2 bis 0,7 hat, y einen Wert von 0,05 bis 0,2 und vorzugsweise von 0,09 bis 0,14 hat und δ einen Wert von -0,6 bis 0 und vorzugsweise von -0,48 bis -0,07 aufweist.

Ein besonderer Vorteil des erfindungsgemäßen Mischkristallsbesteht darin, dass er als Schicht unter Einsatz bekannter Beschichtungstechnologien in der α - Phase abgeschieden werden kann. Dies ist mittels physikalischer Gasphasenabscheidung oder einer Kombination aus physikalischer und chemischer Gasphasenabscheidung möglich.

Vorzugsweise wird die Magnetron Kathodenzerstäubung eingesetzt, wobei die reaktive Hochfrequenz Magnetron Kathodenzerstäubung besonders bevorzugt ist. Hierzu wird das Substrat in eine Vakuumkammer eingebracht und die Vakuumkammer wird evakuiert. Die Substratoberfläche wird gereinigt, vorzugsweise durch Ionenbeschuss. Nach der Reinigung wird eine Substrattemperatur im Bereich von 200 °C bis 700 °C, vorzugsweise im Bereich von 350°C bis 500°C, sowie eine Substratvorspannung zwischen 0 V und - 400 V, vorzugsweise zwischen 0 V und -100 V eingestellt. Ein Gasfluss aus mindestens den Gasen Argon, Sauerstoff und Stickstoff wird eingestellt und ein Plasma erzeugt und gezündet. An den Kathoden, die Al und Cr umfassen, wird eine Leistung angelegt sodass eine Schicht aus einem hexagonalen Mischkristall aus einem AL-Cr-O-N Stoffsystem auf dem Substrat abgeschieden wird. Durch das Einstellen einer Probenbewegung entsteht flächig eine Beschichtung auf dem Substrat. Die beschichteten Substrate werden abgekühlt und können entnommen werden.

Die Schichten mit der erfindungsgemäßen Zusammensetzung und Struktur sind aufgrund ihrer Härtewerte besonders für die Verwendung als Hartstoffschicht geeignet.

Nachfolgend wird die Erfindung anhand von Beispielen näher erläutert.

Tabelle 1 und 2 enthalten für jeweils eine Probenserie die Vickershärte HV 0,05, die chemische Zusammensetzung in Atomprozent (at.-%), sowie die daraus berechneten Variablen x, y und δ. Für die in den Tabellen 1 und 2 genannten Proben wurde durch Röntgenbeugungsuntersuchungen eine hexagonale Struktur nachgewiesen.

**Tabelle 1: Chemische und stöchiometrische Zusammensetzung einer Probenserie 1 und Angaben zur Vickershärte HV 0,05**

| | Probe | | | | |
|---|---|---|---|---|---|
| | 1 | 2 | 3 | 4 | 5 |
| Al in at.-% | 23,2 | 19,3 | 15,4 | 11,4 | 7,5 |
| Cr in at.-% | 10,4 | 14,9 | 19,4 | 23,8 | 28,3 |
| O in at.-% | 57,7 | 57,7 | 57,7 | 57,7 | 57,7 |
| N in at.-% | 8,7 | 8,1 | 7,6 | 7,1 | 6,5 |
| (Al+Cr) / (O+N) | 0,507 | 0,519 | 0,532 | 0,545 | 0,558 |
| x=Al / (Al+Cr) | 0,690 | 0,564 | 0,442 | 0,324 | 0,209 |
| y=N / (N+O) | 0,131 | 0,124 | 0,116 | 0,109 | 0,102 |
| δ=3*(Al+Cr) / (O+N)-2 | -0,479 | -0,442 | -0,404 | -0,366 | -0,327 |
| HV0,05 | 1802±42 | 1783±27 | 1461±96 | 1203±68 | 1290±63 |

**Tabelle 2: Chemische und stöchiometrische Zusammensetzung einer Probenserie 2 und Angaben zur Vickershärte HV 0,05**

| | Probe | | | | |
|---|---|---|---|---|---|
| | 1 | 2 | 3 | 4 | 5 |
| Al in at.-% | 24,7 | 20,3 | 16,0 | 11,6 | 7,2 |
| Cr in at.-% | 14,3 | 17,6 | 20,9 | 24,2 | 27,5 |
| O in at.-% | 55,2 | 56,0 | 56,8 | 57,6 | 58,4 |
| N in at.-% | 5,8 | 6,0 | 6,3 | 6,6 | 6,9 |
| (Al+Cr) / (O+N) | 0,640 | 0,612 | 0,584 | 0,557 | 0,531 |
| x=Al / (Al+Cr) | 0,633 | 0,536 | 0,433 | 0,324 | 0,208 |
| y=N / (N+O) | 0,094 | 0,097 | 0,100 | 0,103 | 0,106 |
| δ=3* (Al+Cr) / (O+N)-2 | -0,079 | -0,165 | -0,248 | -0,329 | -0,406 |
| HV0,05 | 2165±35 | 1873±72 | 1632±73 | 1560±38 | 1658±60 |

Der Einfluss des im Mischkristall vorhandenen Stickstoffs wird anhand von Tabelle 3 verdeutlicht, in der ein aus dem Stand der Technik bekannter AlCrO Mischkristall in hexagonaler Form hinsichtlich seiner chemischen und stöchiometrischen Zusammensetzung, sowie Vickershärte HV 0,05 dargestellt ist.

**Tabelle 3: Chemische und stöchiometrische Zusammensetzung einer AlCrO Vergleichsserie und Angaben zur Vickershärte HV 0,05**

| | Probe | | | | |
|---|---|---|---|---|---|
| | 1 | 2 | 3 | 4 | 5 |
| Al in at.-% | 27,4 | 25,0 | 17,8 | 13,5 | 9,8 |
| Cr in at.-% | 11,3 | 14,2 | 22,4 | 26,9 | 30,1 |
| O in at.-% | 61,1 | 60,6 | 59,6 | 59,4 | 59,8 |
| N in at.-% | 0,0 | 0,0 | 0,0 | 0,0 | 0,0 |
| (Al+Cr) / (O+N) | 0,633 | 0,646 | 0,674 | 0,679 | 0,667 |
| x=Al / (Al+Cr) | 0,708 | 0,637 | 0,442 | 0,333 | 0,246 |
| y=N / (N+O) | 0,000 | 0,000 | 0,000 | 0,000 | 0,000 |
| δ=3* (Al+Cr) / (O+N)-2 | -0,102 | -0,061 | 0,021 | 0,038 | 0,001 |
| HV0,05 | 1579±41 | 1641±54 | 1206±58 | 1082±72 | 994±40 |

Aus den Tabellen 1 bis 3 ist ersichtlich, dass die Proben, die Stickstoff enthalten bei einer vergleichbaren stöchiometrischen Zusammensetzung jeweils höhere Werte für die Vickershärte HV 0,05 aufweisen.

Die in den Tabellen 1 und 2 gezeigten Proben wurden als Schichten auf einem gereinigten Hartmetallsubstrat abgeschieden. Die Reinigung der Substratoberfläche durch Ionenbeschuss ist dabei besonders vorteilhaft. Die Oberfläche des Substrats wurde durch Hochfrequenzkathodenzerstäubung mit einer Al-Cr Haftvermittlerschicht beschichtet, um ein Abplatzen der Oxidschicht vom Hartmetallsubstrat durch die Entstehung von Eigenspannungen zu verhindern. Die Haftvermittlerschicht umfasst bevorzugt eine Cr-Schicht und eine Al-Cr Schicht, wobei die Dicke der Cr-Schicht vorzugsweise in einem Bereich von 0,2 µm bis 1,5 µm liegt, besonders bevorzugt ist eine Dicke der Cr-Schicht von 0,3 µm bis 1,3 µm. Die Al-Cr Schicht ist vorzugsweise 0,3 µm bis 1 µm dick.

Alle Proben wurden mit einer segmentierten Al/Cr Kathode mit einer Hochfrequenzleistung von 500 W bei einer Substrattemperatur von 500°C auf einer Standardbeschichtungsanlage abgeschieden. Die beiden Probenserien unterscheiden sich hinsichtlich der während der Abscheidung eingestellten Gasflüsse und dem daraus resultierenden Gesamtgasdruck.
Probenserie 1 wurde mit einem Gesamtgasfluss aus 37,5 sccm Argon, 9,4 sccm Sauerstoff und 10 sccm Stickstoff gefertigt.
Probenserie 2 wurde mit einem Gesamtgasfluss aus 37,5 sccm Argon, 7,0 sccm Sauerstoff und 2,3 sccm Stickstoff gefertigt.

Schichten mit den eingangs genannten Eigenschaften eignen sich aufgrund ihrer gesteigerten Härte und daraus resultierenden Verschleißeigenschaften besonders als Hartstoffschicht.

## Patentansprüche

1. Hexagonaler Mischkristall aus einem Al-Cr-O-N Stoffsystem mit der Zusammensetzung
α-(Alₓ,Cr₁₋ₓ)_{2+δ} (O_{1-y}, N_{y})₃,
wobei α die hexagonale Gitterstruktur bezeichnet, x einen Wert von 0,1 bis 0,9 hat, y einen Wert von 0,09 bis 0,2 hat und δ einen Wert von -0,6 bis 0 aufweist.

2. Hexagonaler Mischkristall nach Anspruch 1, wobei x einen Wert von 0,2 bis 0,7 hat, y einen Wert von 0,09 bis 0,14 hat und δ einen Wert von -0,48 bis -0,07 aufweist.

3. Hexagonaler Mischkristall nach einem der Ansprüche 1 oder 2, wobei der Mischkristall einphasig ist.

4. Hexagonaler Mischkristall nach einem der Ansprüche 1 bis 3, wobei der Mischkristall auf einem Substrat aufgebracht ist und auf dem Substrat eine Schicht bildet.

5. Hexagonaler Mischkristall nach Anspruch 4, wobei zwischen dem Substrat und dem Mischkristall eine Haftvermittlerschicht aufgebracht ist.

6. Verwendung des hexagonalen Mischkristalls nach einem der Ansprüche 1 bis 5 als Hartstoffschicht.

## Claims

1. Hexagonal co-crystal formed from an Al-Cr-O-N system and having the composition
α-(Alₓ,Cr₁₋ₓ)_{2+δ} (O_{1-y}, N_{y})₃
where α denotes the hexagonal lattice structure, x has a value of 0.1 to 0.9, y has a value of 0.09 to 0.2 and δ has a value of -0.6 to 0.

2. Hexagonal co-crystal according to Claim 1, where x has a value of 0.2 to 0.7, y has a value of 0.09 to 0.14 and δ has a value of -0.48 to -0.07.

3. Hexagonal co-crystal according to either of Claims 1 and 2, wherein the co-crystal is monophasic.

4. Hexagonal co-crystal according to any of Claims 1 to 3, wherein the co-crystal is applied atop a substrate and forms a layer on the substrate.

5. Hexagonal co-crystal according to Claim 4, wherein an adhesion promoter layer is applied between the substrate and the co-crystal.

6. Use of the hexagonal co-crystal according to any of Claims 1 to 5 as hard material layer.

## Revendications

1. Cristal mixte hexagonal constitué par un système de matière Al-Cr-O-N ayant la composition
α-(Alₓ, Cr₁₋ₓ)_{2+δ} (O_{1-y}, N_{y})₃,
α désignant la structure de réseau hexagonale, x ayant une valeur de 0,1 à 0,9, y ayant une valeur de 0,09 à 0,2, et δ présentant une valeur de -0,6 à 0.

2. Cristal mixte hexagonal selon la revendication 1, dans lequel x a une valeur de 0,2 à 0,7, y a une valeur de 0,09 à 0,14, et δ présente une valeur de -0,48 à - 0,07.

3. Cristal mixte hexagonal selon l'une quelconque des revendications 1 ou 2, dans lequel le cristal mixte est monophasé.

4. Cristal mixte hexagonal selon l'une quelconque des revendications 1 à 3, dans lequel le cristal mixte est appliqué sur un substrat et forme une couche sur le substrat.

5. Cristal mixte hexagonal selon la revendication 4, dans lequel une couche de promoteur d'adhésion est appliquée entre le substrat et le cristal mixte.

6. Utilisation du cristal mixte hexagonal selon l'une quelconque des revendications 1 à 5 en tant que couche de matière dure.
